# DEMANDE DE BREVET EUROPEEN

(11) **EP 1 298 805 A1**
(43) Date de publication de la demande: **02.04.2003**
(21) Numéro de dépôt: 02292329.6
(22) Date de dépôt: 23.09.2002
(51) Int. Cl.: H03M 13/23, H03M 13/35, H03M 13/37, H03M 13/39, H03M 13/47

(54) **Procédé et dispositif de codage et de décodage convolutifs**

(30) Priorité: 01.10.2001 FR 0112594
(71) Demandeur: ALCATEL, 75008 Paris (FR)
(72) Inventeur: Gallet, Thibault, 31600 Seysses (FR); Marguinaud, André, 91120 Palaiseau (FR); Romann, Brigitte, 92500 Rueil-Malmaison (FR)
(74) Mandataire: Korakis-Ménager, Sophie

(57) **Abrégé**

L'invention permet la transmission de données avec encodage convolutif, où elle prévoit de réaliser, sur au moins une portion de données, des encodages indépendants séparés et rebouclés sur eux-mêmes. Ainsi, les données sont réparties sur un ou plusieurs cycles. Le groupement de plusieurs cycles en paquets permet une transmission discontinue lorsque nécessaire.

Le décodage pondéré est réalisé indépendamment cycle par cycle : l'invention prévoit de commencer à un lieu robuste (LR), de vraisemblance relativement élevée, et de terminer le décodage à un lieu faible (LF) de vraisemblance faible, en s'affranchissant de la notion de temps. Cela permet de limiter la taille des paquets d'erreurs lorsqu'ils surviennent et d'empêcher la propagation des paquets d'erreurs dû à un brouillage intentionnel ou non.

L'encodage et le décodage indépendants de données sont réalisables sans échanges de paramètres entre cycles et les paramètres de chaque cycle (taille ; redondance ; et longueur de contrainte) et peuvent être distincts. Ce traitement permet de spécifier différents degrés de protection et de retard en fonction de la nature des données à transmettre (voix ; données numériques ; signalisation etc..), d'autant que les cycles peuvent être courts : des performances identiques à celles obtenues dans le cas des codes convolutifs infinis sont obtenus à partir d'une soixantaine de bits pour le cas particulier du rendement ½ avec la longueur de contrainte 7.

## Description

L'invention concerne le codage correcteur d'erreurs de la transmission de données numériques, ces dernières pouvant être sous forme de paquets distincts ou sous forme de flot continu. Dans le cadre de l'invention, il existe plusieurs techniques d'accès à la ressource de transmission envisageables :
- technique de transmission par paquets, de type AMRT (Accès Multiple par Répartition dans le Temps) où les paquets modulés partagent la même porteuse (technique connue sous la dénomination anglo-saxonne de TDMA) ; de type EVasion de Fréquence où les paquets modulés changent de fréquence porteuse à chaque saut porteuse (technique connue sous la dénomination anglo-saxonne de Frequency Hopping) ;
- technique de transmission continue, de type AMRF (Accès Multiple par Répartition en Fréquence) où la transmission continue des données est réalisée sur la même fréquence porteuse (technique connue sous la dénomination anglo-saxonne de FDMA) ; de type AMRC (Accès Multiple par Répartition par le Code) où la transmission continue des données est étalée par un code PN à séquence directe (technique connue sous la dénomination anglo-saxonne de CDMA),
- ainsi que toute technique combinant plusieurs de ces modes d'accès.

Les modulations envisagées sont des modulations numériques de tout type sur les données à transmettre. Par exemple, la modulation 4-PSK associe un symbole modulé à tout couple de deux bits, tandis que la modulation 16 QAM associe un symbole modulé à tout quadruplet de bits.

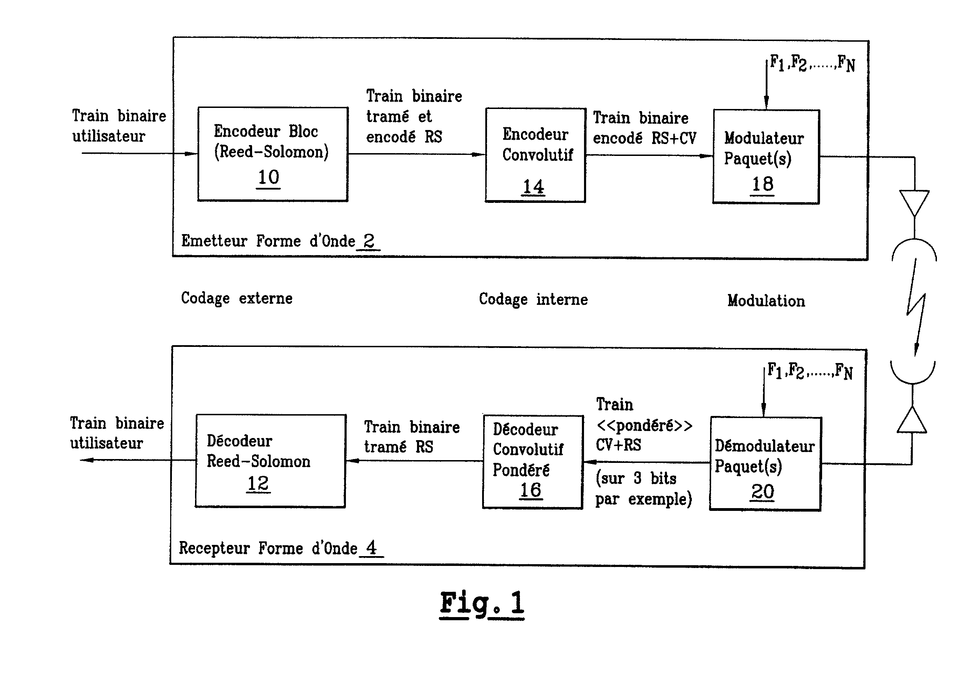

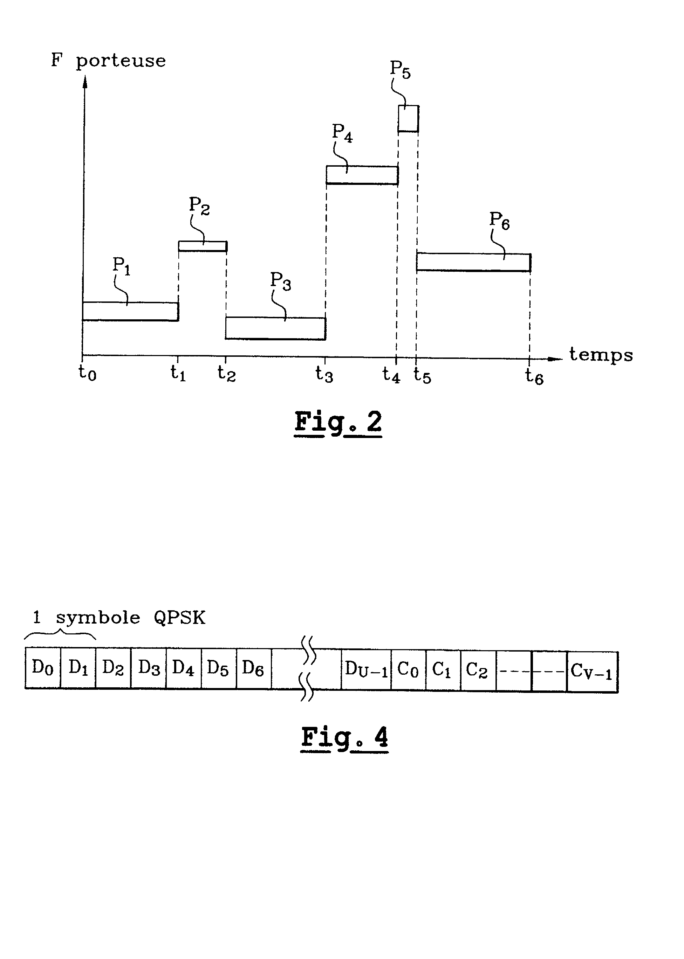

A titre illustratif, les figures 1 et 2 illustrent le principe de transmission dans le cas d'une transmission numérique par paquets sautant en fréquence, où l'information est transmise palier de fréquence par palier de fréquence, chaque palier comportant un paquet de données modulé par une fréquence porteuse de valeur distincte (F₁, F₂, ....F_{N}).

La figure 1 représente sous forme de schéma bloc la mise en oeuvre système traditionnelle 1 de la voie de transmission sautant en EVF, comprenant une partie émettrice 2 et une partie réceptrice 4.

La figure 2 représente symboliquement l'évolution dans le temps de la porteuse F de la partie émettrice 2. On note que l'émission de données, représentées par des rectangles, s'opère sur des intervalles de temps variables d'un saut au suivant. Par ailleurs, la plage de fréquence occupée par la porteuse est également variable sur ces intervalles.

Toute transmission est sujette à des perturbations radioélectriques (ou autres) involontaires (bruit naturel du récepteur, conditions de fonctionnement, bruit industriel, fadings sélectifs) ou volontaires (brouillage continu, impulsionnel ou sélectif).

Afin d'accroître l'efficacité énergétique de la transmission compte-tenu de ces effets, on met usuellement en oeuvre des codes correcteurs d'erreurs visant à récupérer les symboles corrompus par ces perturbations. Pour protéger les bits de donnée, on augmente le débit de transmission. On appelle R la proportion du nombre de bits de données relativement au nombre total de bits transmis. Le rendement d'un code est d'autant plus grand que R est élevé.

Il est usuel d'implanter deux types de codages en amont du modulateur 18, et d'y associer leurs deux décodages en aval du démodulateur 20. Le premier, le plus proche du modulateur, appelé code interne, est généralement un code convolutif pondéré 14 sans tramage (ou infini). Les données sont encodées au moyen d'équations de contrôle glissantes. Le décodage à entrées pondérées associé (dit aussi à "soft decoding" en terminologie anglo-saxonne) utilise généralement l'algorithme de Viterbi. Les rendements usuels de ce type de code (ou de leurs combinaisons) sont 1/2; 3/4; 1/3 etc...

Le deuxième codage, appelé code externe, est en général un code bloc (tramé) à sorties «dures» ou binaires, de type Reed-Solomon 10, et permet de réduire, voire d'annuler, les erreurs résiduelles afin d'atteindre les performances finales spécifiées.

De manière générale, la démodulation a pour objet d'estimer la valeur des symboles qu'il démodule, et d'en qualifier la vraisemblance au moyen d'une valeur numérique quantifiée plus ou moins finement suivant les réalisations matérielles.

La mise en oeuvre matérielle usuelle est réalisée à base de processeurs et de composants dédiés. La fonction MODEM est réalisée dans un (ou des) composant(s) distinct(s) de celui du code convolutif pondéré. En conséquence, les données pondérées issues du démodulateur vers le décodeur convolutif ("soft decoding") sont quantifiées avec un nombre limité de bits (3 bits en général).

En sortie du décodage convolutif pondéré, on obtient un train binaire RS (Reed-Solomon) qui est soumis à un décodage RS 12 afin d'obtenir en sortie un train binaire utilisateur

Dans l'état de l'art, un code convolutif 14 de rendement R=½ utilise deux polynômes à fin d'encodage. Le degré (K-1) des polynômes définit la longueur de contrainte K du code et se manifeste par un retard en symboles sur l'encodage.

A titre d'exemple, lorsqu'on utilise deux polynômes de degré 6 dans le cas de R= ½, K vaut 7. Toujours dans le cas R=½, lorsqu'on utilise des polynômes de degré 8, K vaut 9.

Ainsi, lorsque le dépassement de la capacité de correction du décodeur (liée à la longueur de contrainte K du code) entraîne le décodeur convolutif à éliminer la bonne hypothèse, les retours (lents) sur la bonne hypothèse entraînent des bouffées d'erreurs de durées variables.

Pour remédier à ce problème, deux approches de correction d'erreurs sont généralement proposées avec des codes convolutifs classiques :
i) l'entrelacement de plusieurs codes convolutifs infinis, ce qui a pour effet de disperser les erreurs sur chacun des décodeurs convolutifs afin de diminuer la probabilité d'occurrence des paquets d'erreurs mettant en échec chaque décodeur.
   Toutefois, cette approche complexifie la mise en oeuvre système et augmente le délai de transmission par la mise en oeuvre de l'entrelacement, et, lorsque le mode de transmission est du type dit à évasion de fréquence (EVF), cela nécessite l'introduction d'un estimateur d'amplitude sur chaque palier.
ii) l'ajout de bits de vidage du code à la fin de chaque paquet. Ces bits de vidage engendrent une perte d'efficacité énergétique (Eb/N0) d'autant plus importante que les paquets transmis sont courts.

La première approche présente l'inconvénient de ne pas borner définitivement le phénomène de bouffées d'erreurs, tandis que la deuxième sacrifie systématiquement l'efficacité énergétique de transmission.

On note que le décodage du code convolutif interne peut produire des bouffées d'erreurs de tailles variables, nettement supérieures aux durées des perturbations les ayant engendrées.

Au vu de ce qui précède, l'invention propose une nouvelle approche pour le codage et le décodage de ce type de code permettant notamment de limiter la durée de ces bouffées d'erreurs en sortie du décodeur, sans modification du débit utile, du rendement R, et en maintenant les bonnes performances constatées sur le code conventionnel.

Plus particulièrement, l'invention propose, selon un premier aspect, un procédé d'encodage et/ou de décodage convolutif de bits utilisateur, caractérisé en ce que l'on soumet lesdits bits utilisateur à un système d'équations de contrôle glissant de longueur finie, rebouclé sur lui-même.

L'encodage peut être du type dit "séparé", la concaténation des bits utiles et des bits de redondance constituant les bits présentés en sortie.

L'invention permet de regrouper les bits à présenter en sortie sur une ou plusieurs portion(s), formant un ou plusieurs cycles(s) respectif(s).

Avantageusement, l'invention permet de caractériser chaque cycle chacun par le quadruplet de paramètres suivants:
- la taille du cycle C (en bits transmis) ;
- le nombre de bits utiles K concernés par le système de contrôle à chaque instant, ce nombre K étant la longueur de contrainte de sorte que (K-1) est le degré maximum des polynômes associés au système d'équations de contrôle ;
- le rendement R, c'est-à-dire le nombre de bits utiles sur le nombre de bits transmis du cycle ; et
- les coefficients des équations du système de contrôle.

Les paramètres de cycle peuvent être sélectionnés de manière indépendante d'un cycle à un autre.

Les cycles, même s'ils appartiennent à un même ensemble utilisateur, peuvent être encodés indépendamment et peuvent donc être décodés indépendamment, sans échange de données ou de paramètres entre cycles.

L'invention permet de regrouper un ou plusieurs cycles en paquets numériques distincts afin de desservir une transmission paquets lorsque nécessaire. Une transmission dite continue est un cas particulier d'un paquet unique de longueur arbitraire. Autrement dit, l'invention permet de coder ou de décoder aussi bien des données qui se présentent selon un flot continu que des données qui se présentent sous forme de paquets.

L'invention permet par ailleurs d'adapter la qualité de service (taux de perte cycles ; taux d'erreurs moyen et retard de transmission) à la nature des données à traiter en adaptant le paramétrage variable de chaque cycle au niveau de l'encodage et du décodage, la qualité de service étant individualisée suivant la nature des données (voix ; données numériques ; signalisation ; en-tête ; etc...).

Lorsque l'invention est mise en oeuvre pour l'encodage, elle peut comprendre une étape d'embrouillage de tout ou d'une partie des bits transmis du cycle.

Le procédé peut être mis en oeuvre sur processeur(s) fonctionnant avec découpe temporelle plutôt que fonctionnelle des tâches à réaliser, sans passation de données entre cycles, ces derniers étant indépendants. Cela permet une intégration de la démodulation et du décodage convolutif cyclique dans un même processeur avec réduction de la perte de quantification pouvant être induite par l'interface des données entre un démodulateur et un décodeur classiques, réalisés par exemple dans deux processeurs distincts.

Lorsque le procédé est mis en oeuvre pour l'encodage, ce dernier peut comprendre les étapes successives de :
- calcul de la réponse impulsionnelle séparée correspondant à la taille C d'un cycle à encoder, et
- d'encodage du message incident.

La réponse impulsionnelle est avantageusement séparée. Elle est précalculée pour chaque type de cycle, et, lorsqu'elle existe, est unique.

De préférence, on réalise une concaténation de cycles de tailles sélectionnées afin d'éviter les tailles de cycles ne rebouclant pas et de s'ajuster à la longueur du message désiré. Ainsi, les multiples 2^{k-1}-1 (dans le cas d'une redondance R=1/2), ne se rebouclent pas.

Dans un mode de réalisation, on établit un taux R de proportion de bits de données relativement au nombre total de bits transmis égal à ½, une réponse impulsionnelle séparée existant lorsque la taille de cycle n'est pas un multiple de 2^{K-1}-1, où K est la longueur de contrainte.

L'encodage est réalisé de préférence à l'aide d'une réponse impulsionnelle séparée calculée à partir d'un message unitaire.

De préférence, ce dernier est constitué d'un ensemble de bits, dont un seul a la valeur binaire "1".

Le calcul de la réponse impulsionnelle peut être réalisé à l'aide d'une séquence de bits de redondance apposée avant le début du message unitaire, la valeur des bits formant ladite séquence étant sélectionnée de manière à ce que l'on retrouve, après le calcul de la réponse impulsionnelle le long du cycle, la même séquence de valeurs dans les derniers bits correspondant de la réponse impulsionnelle.

Avantageusement, la valeur de la séquence des bits de redondance est calculée en essayant toutes les combinaisons possibles de valeurs de bits, jusqu'à obtention de ladite séquence de valeurs dans les derniers bits de redondance du message unitaire après calcul de la réponse impulsionnelle. En effet, les combinaisons possibles peuvent être épuisées dans un temps raisonnable.

L'encodage peut comprendre en outre un encodage général des données par rotations et additions de la réponse impulsionnelle séparée calculée à partir du message unitaire.

De préférence, chaque cycle comporte un nombre faible de bits, par exemple compris dans une plage C de 64 à 150 bits pour (K=7, R= ½) , afin de minimiser la propagation d'erreurs et de garantir la résistance aux perturbations volontaires ou non.

L'invention permet en outre d'envisager un procédé de décodage de données ayant été codées par cycle, notamment par un procédé d'encodage tel que décrit supra, caractérisé en ce que, pour un cycle donné, on commence le décodage à un lieu robuste, de vraisemblance relativement élevée, et l'on termine le décodage à un lieu fragile de vraisemblance faible en s'affranchissant du sens d'écoulement du temps, la vraisemblance du lieu étant calculée sur un nombre de symboles proportionnel au moins à la longueur de contrainte K.

Lorsque le procédé est mis en oeuvre avec un seul encodeur cyclique, le point de départ du décodage est de préférence le lieu le plus robuste et le point de terminaison du décodage est le lieu le plus fragile du cycle à décoder.

La vraisemblance d'un lieu est avantageusement déterminée en fonction de la qualité du signal local estimé par l'équipement amont dans la chaîne de transmission. Lorsque l'équipement amont est le démodulateur, la qualité du signal local est donnée par exemple par le niveau de la porteuse reconstituée sur chaque symbole démodulé, intégré sur la durée de l'hypothèse de décodage auquel il est associé. Lorsque l'équipement amont est relatif à un autre décodeur convolutif cyclique (à la suite de la mise en parallèle des redondances de 2 encodages convolutifs ou de leur concaténation), la qualité du signal local est donnée sur la durée (en nombre de symboles) du décodage déjà effectué.

Le décodage peut commencer par le calcul de la vraisemblance de l'hypothèse sans erreur dans le lieu robuste choisi, ainsi que de celles ayant un nombre limité d'erreurs au même endroit.

Le décodage peut être réalisé par progression dans deux directions opposées pour progresser sur deux côtés d'un lieu faible, chaque direction donnant un jeu d'hypothèses respectives.

Le décodage est peut être poursuivi symbole démodulé par symbole démodulé vers un lieu faible, par augmentation de la durée de la vraisemblance associée à l'hypothèse, en conservant à chaque pas les meilleures hypothèses au sens de la vraisemblance.

A partir des hypothèses respectives, il peut être prévu de produire une hypothèse totale, choisie comme étant celle qui permet de satisfaire les équations du système de contrôle pas à pas tout autour du cycle.

L'hypothèse retenue peut être celle qui présente la vraisemblance maximum.

Selon un deuxième aspect, l'invention prévoit un encodeur configuré pour réaliser le procédé d'encodage selon au moins un des aspects présentés supra.

Selon un troisième aspect, l'invention prévoit un récepteur, caractérisé en ce qu'il comporte un décodeur configuré pour réaliser le procédé de décodage selon au moins un des aspects présentés supra.

Les avantages et caractéristiques de l'invention apparaîtront plus clairement à la lecture de la description qui suit, donnée purement à titre illustratif et non-limitatif, par référence aux dessins annexés, dont :
- La figure 1, déjà décrite, est un schéma illustrant une transmission par sauts de fréquence entre un émetteur et un récepteur conventionnels ;
- la figure 2, déjà décrite, est une représentation graphique de la transmission classique de paquets de données à différentes fréquences porteuses dans le temps ;

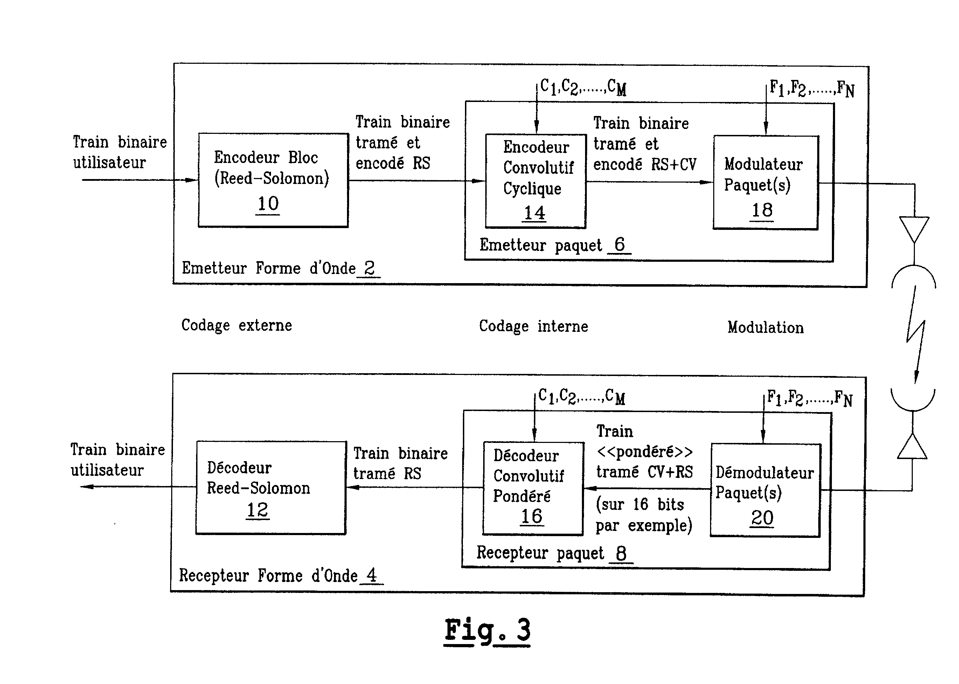

- la figure 3 est un schéma analogue a celui de la figure 1, modifiée pour la mise en oeuvre de l'invention conformément à un mode de réalisation de celle-ci ;

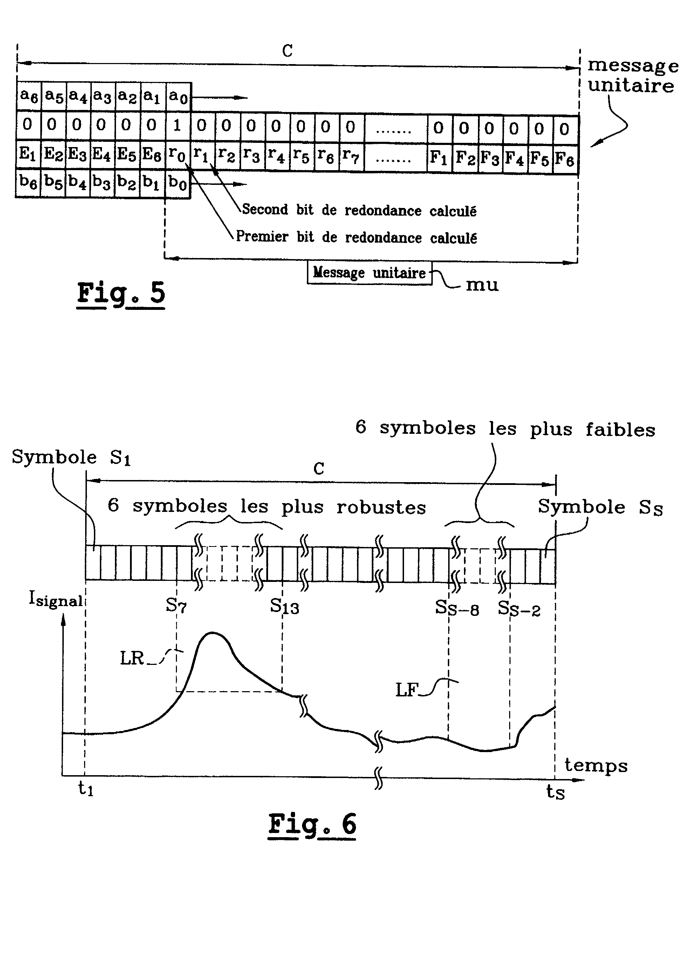

- la figure 4, est un schéma montrant une des répartitions possibles des bits de redondance et de données au sein d'un paquet transmis ;
- la figure 5 est un exemple de calcul de la réponse impulsionnelle séparée, codée conformément à l'invention ;
- la figure 6 est un schéma illustrant le principe d'identification de lieu robuste et de lieu fragile d'un cycle par rapport à la qualité du signal, utilisé dans le cadre du décodage de l'invention ; et

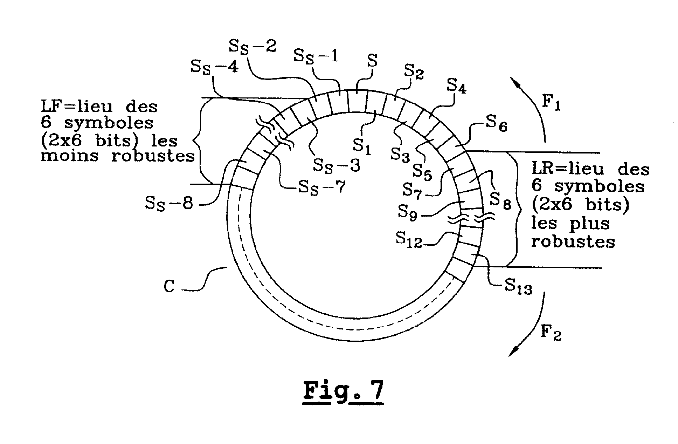

- la figure 7 est un schéma illustrant la notion de rebouclage des bits d'un cycle et de chemin de décodage d'un lieu robuste vers un lieu fragile, utilisée pour le décodage.

Avant de décrire un exemple spécifique de mise en oeuvre, on abordera des aspects généraux et des principes d'un mode de réalisation de l'invention.

Le mode de réalisation exploite le fait que l'invention permet de découper un flot binaire à transmettre en portions de signal appelées cycles, que l'on encode chacun au moyen d'un système d'équations de contrôle glissant rebouclé sur lui-même. On les décode au moyen du même système d'équations de contrôle glissant.

D'un point de vue matériel, la découpe du code interne en cycles inférieurs à la taille du paquet, permet d'associer les encodeurs et les décodeurs cycliques au modem paquet, sans passation de données d'un paquet à l'autre entre les codeurs /décodeurs. Ainsi en découpant temporellement les tâches à réaliser plutôt qu'en les séparant par fonctions, on évite la limitation de la quantification des vraisemblances symbole du démodulateur (en vue du soft decoding), ce qui est le cas lorsque le composant de décodage convolutif pondéré est extérieur au modem. Seul le code externe assure le chaînage des paquets reçus en vue de leur fourniture à l'utilisateur final.

Ainsi la structure cyclique est directement adaptée au mode d'accès paquets par concaténation de cycles de longueurs adéquates.

L'invention permet donc de travailler avec des paquets sans liaison entre eux (non consécutifs dans le temps), sans sauvegarde du contexte.

Le mode continu est un cas particulier du modem paquets, où N=1, c'est-à-dire que le modem émet continûment ses données modulées sur une seule fréquence porteuse F1.

Alors que dans ce cas, la mise en oeuvre traditionnelle ne prévoit qu'une structure de trame sur le code externe, imposée par la taille du code bloc de Reed-Solomon, dans le cadre de l'invention, le train continu transmis par le modem est alors structuré en trames dès le code interne, par la longueur des cycles définie, comme représenté sur la figure 3.

Dans le mode de réalisation, l'encodage est séparé, c'est-à-dire que les bits de redondance n'altèrent pas les bits de données qui sont également transmis vers le modulateur. La concaténation des bits utiles et des bits de redondance constitue les bits transmis. Cela permet, le cas échéant, au niveau du décodeur, de laisser "passer " les données utiles sans correction lorsque l'on a détecté par ailleurs une incapacité du code à corriger.

Dans le cas d'un rendement R du code quelconque, la manière d'incorporer des bits de redondance dans un paquet (positionnement relativement aux bits de données, nombre, etc.) n'est pas unique. A titre d'exemple, la figure 4 représente une répartition possible des bits de redondance C₀,C₁, C₂, ....Cᵥ₋₁ parmi les bits de données D₀,D₁,D₂,.... Dᵤ₋₁ pour un paquet. Dans cet exemple, l'ensemble des données est séparé de l'ensemble des redondances, ce qui permet, même après regroupement des bits par symboles à fin de modulation, de générer des symboles de données séparées des symboles de redondance. Sur la figure 4, on a regroupé les bits par couple en supposant que le modem utilise une modulation 4-PSK.

Au vu de ce qui précède, l'invention propose un système d'encodage et de décodage qui borne le nombre d'erreurs de décodage et évite leur propagation, tout en conservant le niveau de performance théorique et le niveau de complexité de réalisation d'un encodeur et d'un décodeur convolutif infinis conventionnels.

Typiquement les cycles, même s'ils appartiennent à une même transmission, sont encodés indépendamment et de ce fait décodés indépendamment, sans échange de données ou de paramètres entre cycles. Ainsi il n'y pas d'ordre temporel de décodage et les quadruplets de paramètres de chaque cycle peuvent être différents.

Avantageusement, l'encodage se compose de 2 étapes : La 1^{ère} consiste à calculer la réponse impulsionnelle séparée du cycle. Cette réponse, lorsqu'elle existe, est unique par longueur C et n'est calculée qu'une seule fois pour toute la transmission tant que les polynômes utilisés sont conservés. La 2^{ème} étape calcule la redondance de chaque cycle associée à un message utile entrant de longueur u. Cette 2^{ème} étape utilise la réponse impulsionnelle calculée dans la 1ère étape et est à réaliser autant de fois qu'il y a de cycles à encoder.
1) La réponse impulsionnelle séparée est la concaténation d'un message unitaire (MU) de longueur u et de sa redondance associée de longueur v. Les bits de redondances (C0,C1,C2,...Cv-1) sont calculés en imposant pas à pas la vérification des équations de contrôle. Les équations de contrôle sont des équations mathématiques définies à partir des polynômes générateurs classiques. Le message unitaire (MU) est constitué d'un ensemble de bit dont 1 seul a la valeur « 1 ». Les autres bits ont la valeur « 0 ».
   Le calcul des bits de redondance de la réponse impulsionnelle séparée peut être réalisé à l'aide d'une séquence temporaire de bits de redondance apposée avant le début du message unitaire, la valeur des bits formant la séquence de redondance étant sélectionnée de manière à ce que l'on retrouve, après le calcul de la réponse impulsionnelle séparée, la même séquence de valeurs dans les derniers bits de redondance.
   La valeur des bits de redondance est de préférence calculée en essayant toutes les combinaisons possibles car celles-ci sont peu nombreuses en pratique. Ces essais sont réalisés jusqu'à obtention de la même séquence de valeurs dans les derniers bits du message unitaire après calcul de la réponse impulsionnelle séparée.
2) La 2^{ème} étape d'encodage général consiste à rechercher dans le message utile binaire à encoder les bits à « 1 », afin de calculer les bits représentant la redondance du message.

Au départ les bits de la redondance sont mis à « 0 ».
Pour chacun des bits utiles à « 1 » sélectionnés, on fait subir une rotation de la réponse impulsionnelle séparée, en fonction de la position du « 1 » considéré et on additionne la valeur obtenue modulo 2 à la redondance du message en cours d'élaboration.

Selon un troisième aspect, l'invention concerne également le procédé de décodage de données correspondant à l'encodage précédemment décrit, caractérisé en ce que, pour un cycle donné, on commence le décodage en un lieu robuste, de vraisemblance relativement élevée, et on termine le décodage en un lieu fragile de vraisemblance faible en s'affranchissant de la notion de temps. La vraisemblance du lieu est calculée sur un nombre de symboles proportionnel au moins à la longueur de contrainte K.

Avantageusement, le décodage commence par le calcul de la vraisemblance de l'hypothèse sans erreur dans le lieu robuste (LR) choisi, puis de celles avec un nombre croissant d'erreurs, au même endroit.

Dans certains cas, le lieu le plus fragile peut être considéré comme étant les bords physiques du cycle.

La vraisemblance d'un lieu est déterminée en fonction d'informations sur la qualité du signal local issu de l'équipement précédent le décodeur . Dans le cas d'un démodulateur, la qualité du signal local peut être donnée par la porteuse reconstituée sur chaque symbole intégrée sur la durée de l'hypothèse de décodage auquel elle est associée.

Pour information, la porteuse reconstituée en provenance du démodulateur qualifie la qualité du signal (son amplitude) sur la durée minimale possible (1 symbole), relativement aux paramètres de fréquence et phase porteuse estimés par le démodulateur. Les paramètres de porteuse sont estimés dans le démodulateur sur la durée totale du paquet (P) lorsqu'il est court, ou sur une durée correspondant aux constantes de temps de variation de la propagation, dans le cas de paquets longs ou dans le cas du flot continu.

Dans le cas d'un décodeur interne convolutif situé en amont du présent décodeur convolutif cyclique, la vraisemblance du lieu est déterminée par la vraisemblance associée à l'hypothèse de décodage du décodeur amont.

Le décodage est réalisé par progression dans deux directions opposées (F1 et F2) pour converger sur deux côtés d'un lieu faible (LF), chaque direction donnant un jeu d'hypothèses respectives.

De plus le décodage est poursuivi symbole par symbole vers le lieu faible (LF), par augmentation de la durée de la vraisemblance associée à l'hypothèse, en conservant à chaque pas les meilleures hypothèses au sens de la vraisemblance.

A partir des hypothèses respectives, on produit une hypothèse totale, choisie comme étant celle qui permet de satisfaire les équations du système de contrôle pas à pas tout autour du cycle.

L'hypothèse retenue est celle qui présente la vraisemblance maximum.

La solution proposée est basée sur l'idée d'un encodage séparé et rebouclé sur lui-même, effectué indépendamment sur chaque portion du paquet de données à transmettre. Chaque portion est dénommé "cycle" et comporte un nombre déterminé de bits utiles. Lorsque la réponse impulsionnelle séparée d'un cycle de longueur donnée existe, elle est unique. Les longueurs de cycles ne permettant pas de trouver de réponse impulsionnelle séparée sont celles correspondant à (2^{K-1} -1), avec K longueur de contrainte du code. Les longueurs des cycles sont paramétrables et peuvent être courts (de l'ordre de 60 bits pour R=1/2), ce qui permet leur concaténation afin de s'adapter à tout type de paquet.

La description qui suit est donnée seulement pour le cas d'une transmission par paquets distincts, étant clair que les enseignements sont aisément transposables par l'homme du métier à une communication sous forme de flot continu de données.

La méthode de décodage proposée permet de minimiser les bouffées d'erreurs générés en s'affranchissant du temps : on recherche le lieu le plus robuste du cycle pour entamer le décodage et le lieu le plus fragile pour arrêter le décodage.

Pour les paquets de taille importante, la découpe en plusieurs cycles supprime la propagation des erreurs à l'intérieur du paquet puisque, par construction, les cycles sont indépendants.

Ainsi, à la différence de la technique classique d'encodage des paquets, où l'on réalise un code convolutif qui évolue au fil de l'eau, c'est à dire qui a un début mais pas de fin prédéterminée, l'invention vise à exploiter judicieusement la structure en cycles et faire en sorte que l'on réalise un maximum d'opérations sur chaque cycle, de préférence jusqu'à la finalisation du décodage du code interne. Cela conduit à modifier la structure algébrique du code convolutif.

A cette fin, on met en oeuvre une structure algébrique dérivée de la structure algébrique du code convolutif classique : Dans un code convolutif classique, il y a un produit scalaire glissant qui est toujours annulé. Dans le cadre de l'invention, ce produit scalaire glissant qui est toujours annulé, est rebouclé.

La figure 3 représente sous forme de bloc fonctionnel un exemple de mise en oeuvre de cette approche conforme à l'invention, dans le cadre d'un système émetteur-récepteur de données par paquets analogue à celui de la figure 1. Par souci de concision, seules les différences de conception et de fonctionnement vis-à-vis du système de la figure 1 sont données.

Une structure tramée est établie du codage externe jusqu'au modulateur dans l'émetteur, et du démodulateur jusqu'au décodeur externe dans le récepteur. La trame cycle étant de taille inférieure ou égale à la taille d'un paquet modem.

Ainsi le code convolutif ne constitue plus une structure apériodique contraignant le design d'implantation en découpe par fonctions. La découpe par fonctions entraîne le plus souvent une définition d'un interface à nombre de bits limité sur le train « pondéré » CV+RS (en général 3 ou 4 bits sont utilisés pour le soft decoding) .

Dans le cadre de l'invention, la découpe temporelle des tâches par paquets liés au modem permet de paralléliser les processeurs affectés aux traitements des paquets (cf. récepteur paquet 8) lorsque le débit de transmission le nécessite, sans séparer la fonction démodulateur de la fonction de décodage interne. Ainsi le mode de réalisation de l'invention utilise un soft decoding sur 16 bits.

L'intérêt de l'invention réside aussi dans le fait que puisque la structure par cycles est complètement disjointe temporellement, on résiste beaucoup mieux à des actions de brouillage, puisqu'il n'y a pas propagation d'erreurs.

En effet, lorsque, à un moment donné, l'on perd l'initialisation du système de décodage, avec une structure algébrique continue, le temps nécessaire pour retrouver la bonne hypothèse de décodage est très grand. Par contre, si l'on réalise la structure algébrique sur un seul cycle, une perte d'initialisation n'entraîne au plus que la perte de ce cycle, lequel peut être éventuellement récupéré par des techniques connues (par le code externe par exemple).

Dans le cas d'un encodeur convolutif cyclique (taille des cycles de 10 à 1500, K=7, R=½ ) et des polynômes générateurs de degré 6, il a été constaté que les performances de décodage, à partir de paquets d'une longueur de 60 bits, étaient au final aussi bonnes que les performances théoriques sur flot continu, sans le risque de paquets d'erreurs supérieur à 60 bits, observés dans le cas d'une implémentation traditionnelle.. Bien entendu, le taux d'erreurs s'élève pour les cycles de grande taille (par exemple cycles de taille supérieur à 1000 bits). Le phénomène de remontée du taux d'erreurs est d'autant plus sensible que la longueur de contrainte K du code est élevée :Ainsi alors que le TEB d'un cycle de 100 bits est minimal pour le code (K=9, R=1/2), le taux d'erreurs à 250 bits de ce même code est nettement plus élevé.

Il sera maintenant décrit un exemple concret de mise en oeuvre de l'invention en abordant les trois phases de la transmission et de la réception d'un message sous forme de paquet radioélectrique selon une technique de sauts de fréquence (cf. figures 2 à 3) et avec un code convolutif (C=100, K=7 ; R=1/2) et des polynômes de degré K-1 = 6:
- l'encodage d'un message unitaire, ou le calcul de la réponse impulsionnelle séparée,
- l'encodage général du message, et
- le décodage pondéré.

### L'encodage d'un message unitaire, ou le calcul de la réponse impulsionnelle séparée.

Les données utiles à transmettre peuvent être représentées par un vecteur X dont les éléments sont des séries entières. Les données (transmises) encodées peuvent être représentées de la même manière par un vecteur Y dont les éléments sont des séries entières. Les données encodées sont reliées aux données utiles par une relation matricielle finie. Les éléments de la matrice G qui définit cette opération classique sont des polynômes générateurs. On démontre que la matrice G entraîne l'existence de matrices de contrôle H tels que H.Y=0. Etre solution de cette équation constitue une condition nécessaire et suffisante pour que Y soit un mot du code, c'est à dire qu'il existe un X tel que G.X = Y. Les matrices de contrôle H constituent une classe d'équivalence dont certains éléments permettent un encodage séparé pas à pas ayant les mêmes performances que ci-dessus. L'écriture matricielle H.Y=0 peut se mettre sous la forme d'équations mathématiques. Ces équations mathématiques constituent un système d'équations de contrôle général dont on tire le système de contrôle glissant, cité dans l'invention.

La figure 4 présente, sous forme de tableau de bits, un exemple de la constitution de la réponse impulsionnelle séparée d'un message unitaire MU.

Le message unitaire MU est un message de u bits (u étant le nombre de bits utiles du cycle constitué d'un « 1 » et de (u-1) « 0 »).

La réponse impulsionnelle séparée de ce message unitaire, du fait de la séparation données utiles / redondance comporte le message unitaire incident et la succession de bits de redondance associés désignés par r0, r1, ....r20....F1, ..F6.

Conformément à l'invention, on ajoute en amont du message unitaire MU une séquence de bits, au nombre de six dans l'exemple, désignés E1 à E6. La valeur de l'ensemble de bits E1 à E6 de la séquence est choisie de manière à ce que la réponse impulsionnelle séparée du tout formé de cet ensemble de ces bits E1 à E6 suivi des bits de redondance r0, r1, ....r20. rende, pour les six derniers bits F1 à F6 de la réponse impulsionnelle séparée, les mêmes valeurs successives que celles des bits successifs E1 à E6. Les bits de redondance ne sont transmis qu'une seule fois.

Autrement dit, on détermine une combinaison de valeurs "0" et "1" pour la séquence de bits ajoutés en amont E1 à E6 de sorte que l'on obtienne, après le calcul de la réponse impulsionnelle séparée, les égalités E1=F1, E2=F2, E3=F3, E4=F4, E5=F5 et E6=F6 pour les bits correspondants. Lorsque ces égalités sont satisfaites, on a alors réalisé les conditions dites de rebouclage, c'est à dire la vérification du système d'équation de contrôle.

Avantageusement, le message unitaire MU avant le calcul de la réponse impulsionnelle séparée est composé d'un seul bit dont la valeur binaire est "1", le complément du message étant constitué de bits dont la valeur binaire est "0".

Pour déterminer la bonne combinaison des bits E1 à E6 qui rend les conditions de rebouclage, on utilise avantageusement une recherche exhaustive plutôt qu'une méthode algébrique. Ce choix s'appuie sur le fait qu'il n'existe qu'un nombre relativement faible de bits de redondance possibles inconnus (six dans le cas d'espèce), et qu'il suffit de tous les essayer (2⁶ possibilités) afin de déterminer les seuls qui donnent le rebouclage.

Plus particulièrement, on balaie toutes les possibilités de combinaison pour les bits E1, E2, ..., E6, en calculant à chaque fois les bits de redondance r0, r1, r2, ..r7, jusqu'aux bits F1, F2, ...., F6, jusqu'à obtenir la combinaison qui rende les égalités E1=F1, E2=F2, E3=F3, E4=F4, E5=F5 et E6=F6.

Bien entendu, le nombre de bits de redondance E1, .. ajoutés en amont du message unitaire peut être autre que six, selon le système d'équations de contrôle choisi.

L'encodage est réalisé par des polynômes de contrôle ayant un nombre K de coefficients. Dans l'exemple, le paramétrage est le suivant :
- nombre K de coefficients des polynômes de contrôle : 7, soit K=7 ;
- rendement R entre le nombre de bits de données et le nombre de bits transmis : ½, soit R=½.

L'encodage est ici identifié par les paramètres K et R précités sous la forme (K,R), soit (7, ½) pour le cas d'espèce.

Les coefficients des polynômes de contrôle sont exprimés par les bits a0, a1, ...., a6 et b0, b1, ..., b6, repérés respectivement sur les lignes supérieures et inférieures du tableau de la figure 4.

### L'encodage général du message.

Pour réaliser l'encodage général du message on commence par calculer ce que l'on dénomme une réponse impulsionnelle séparée, c'est-à-dire que l'on encode un message unitaire de manière cyclique. Ensuite, la structure linéaire du code permet de faire des additions (modulo 2) de réponses impulsionnelles séparées correctement décalées pour encoder l'ensemble du message : typiquement on décale cycliquement le MU de manière à faire correspondre son « 1 » au « 1 » du message à encoder puis on somme les redondances du MU ainsi décalées à la redondance précédente du message (modulo la longueur du cycle), les redondances du message sont initialisées à 0 au début du procédé.

Dans la pratique, on calcule la réponse impulsionnelle séparée au préalable et on la stocke, car elle est invariable tant que l'on garde le mêmes système d'équations de contrôle et la même longueur de cycle. Cette réponse impulsionnelle, lorsqu'elle existe, est unique.

La demanderesse a constaté et démontré que dans le cas de R=1/2, le rebouclage est possible pour toutes les tailles de cycle, sauf les multiples de 2^{K-1}-1, où (K-1) est le degré des polynômes de contrôle. Par exemple, dans le cas particulier K=7, on ne peut pas reboucler les messages dont la taille est un multiple de 2⁶-1=63. Toutefois, cela n'a guère d'incidence sur le plan pratique, puisqu'il est aisé de concaténer des cycles de longueurs différentes pour s'ajuster à la longueur du message désiré.

### Le décodage pondéré.

La figure 6 illustre un cycle issu d'un paquet reçu, le cycle étant constitué d'un nombre s de symboles, par exemple 64, le premier S1 étant reçu à un temps t1, et le dernier Ss étant reçu à un temps ts.

Sous la représentation de ce cycle est montré l'évolution dans le temps [t1,ts] de l'amplitude de la porteuse reconstituée. Cette amplitude étant fluctuante sur cet intervalle, on peut établir un groupe de bits successifs, formé 2*6 bits (pour le cas d'un encodage (7,1/2), situé sur une partie d'amplitude élevée relativement au reste du signal de la porteuse reconstituée pour ce cycle. Dans l'exemple illustré, ce groupe est constitué des douze bits appartenant aux six symboles S7 à S13 (la modulation de l'exemple est QPSK mais elle n'est pas limitative, l'invention pouvant être mise en oeuvre avec d'autres modulations). Conformément à l'invention, ces bits, situés au lieu LR le plus robuste, serviront de point de départ du décodage. Lorsque le départ de décodage provient de la sortie d'un autre décodeur convolutif, l'intervalle de départ d'estimation de la vraisemblance peut être plus long que 2*6 bits.

De même, il existe un groupe d'au moins 2*6 bits situé à une partie d'amplitude faible relativement au reste du signal. Dans l'exemple, ce groupe situé au lieu LF le plus faible est constitué des symboles Ss-8 à Ss-2.

Comparativement aux autres décodages pondérés qui existent, dans le cas de cycles on s'affranchit complètement du temps. La notion de temps n'a plus d'implication sur le décodage pondéré. Autrement dit, le point de début du décodage peut être choisi de manière arbitraire. On peut ainsi stocker un cycle dans une mémoire et rechercher le lieu le plus favorable, par rapport à la structure du signal ou du système de transmission, pour commencer à décoder. Avantageusement, on recherche le lieu le plus robuste LR du cycle, c'est-à-dire le lieu de plus grande vraisemblance ou de maximum d'amplitude du signal pondéré reçu. En effet, on peut estimer que si, sur les (K-1) symboles (par exemple) qui se suivent, les amplitudes sont grandes, les probabilités d'erreurs sur ces bits sont minimales, statistiquement, par rapport à un autre lieu où le signal est d'amplitude plus faible.

Pour réaliser l'opération de décodage, on traite les symboles S1 à Ss comme s'ils étaient répartis sur un cercle, le symbole S1 étant adjacent au symbole Ss, suivant ce rebouclage, comme le montre la figure 7. Cet agencement permet de choisir le point de départ arbitrairement dans le temps, tout en gardant l'ordre de succession des symboles du cycle.

Une fois les conditions de décodage ainsi déterminées, on commence le décodage pas-à-pas en partant des côtés. L'approche étant basée sur la notion de cercle, le décodage procède en sens opposés : anti-horaire (flèche F1) et horaire (flèche F2), à partir du lieu le plus robuste LR des symboles S7 à S13 jusqu'à converger vers le lieu LF le plus faible comportant les symboles les moins robustes Ss-8 à Ss-2 , ces derniers constituant le point de convergence.

Durant le décodage en cercle, on ne passe jamais complètement sur le lieu LF le plus faible, soit le plus défavorable. On a donc le moins de chance de perdre la bonne hypothèse à cause d'un passage sur le lieu le plus défavorable. De même, l'on peut éviter de passer sur des lieux défavorables intermédiaires lorsque l'on a la possibilité d'exploiter la redondance d'un autre code correcteur portant sur les mêmes données (permutées par exemle), et que celle-ci s'avère plus intéressante.

Le plus souvent, les parcours de décodage dans les deux sens F1 et F2 ne sont pas égaux, car le lieu LF le plus défavorable n'a pas de raison a priori de se trouver diamétralement opposé au lieu LR le plus robuste. Le décodage pondéré est réalisé pas-à-pas, ce qui consiste à prolonger les hypothèses qui sont les plus vraisemblables, donc qui ont la porteuse reconstituée la plus grande. La durée de l'intégration de la vraisemblance de l'hypothèse augmente d'un symbole à chaque pas. Typiquement, le nombre de meilleures d'hypothèses conservées est de l'ordre de 300 pour le cas d'espèce.

Dans le cas général, on dispose de plusieurs lieux de départ favorables, dont un préférentiel, et d'un lieu très défavorable. Si un lieu très défavorable se trouve être adjacent ou contigu sur un côté au lieu le plus favorable, on part de l'autre côté, et on réalise un décodage sur un seul chemin.

On peut concevoir que lorsque l'on se trouve dans une situation extrême où le lieu très favorable est entouré de part et d'autre de lieux défavorables, on pourra, à ce moment là, rechercher un lieu légèrement moins favorable, mais mieux situé.

Lorsque l'on passe du lieu LR le plus robuste pour converger vers le lieu LF le plus faible, on obtient un jeu d'hypothèses pour chaque sens d'avancement (flèches F1 et F2) vers la convergence depuis la gauche et la droite. A partir de ces deux jeux d'hypothèses (gauche et droite), on produit une hypothèse "totale". Cette hypothèse totale est choisie comme étant celle qui permet de vérifier le système d'équations de contrôle pas à pas tout au long du cycle. Autrement dit, on prend parmi les hypothèses à droite et à gauche celles qui ont même départ, même arrivée (donc qui se rebouclent), on choisit ensuite celle qui a la vraisemblance la plus importante.

On note de ce qui précède que sur un cycle, on peut s'affranchir du temps. Pour décoder, on procède de la manière suivante :
- choix du lieu LR le plus "robuste": indices de vraisemblance des 2*6 bits (dans le cas (7,1/2)) consécutifs les plus forts ;
- en place: calcul de la vraisemblance de l'hypothèse sans erreur dans cette zone, puis celles avec 1; 2; 3; ... erreurs ;
- prolongement de part et d'autre (flèches F1 et F2) le long du cycle du lieu LR plus robuste, symbole par symbole, en conservant à chaque pas les meilleures hypothèses (au sens de la vraisemblance)
- rebouclage final sur le lieu LR le plus fragile du cycle (effectif).

Le mode de réalisation établit la robustesse des données sur la base des amplitudes du signal reconstitué. Mais on peut considérer toute autre information qui permettrait d'indiquer la qualité du signal et ainsi de déceler les parties à fort taux d'erreurs, par exemple, en utilisant la sortie de codes convolutifs envoyés en parallèle ou concaténés ; en exploitant les résultats des codes externes entrelacés.

Par ailleurs le procédé d'encodage/décodage permet d'embrouiller tout ou partie des bits transmis du cycle pour des raisons de statistique ou de secret, sans dégradation des performances.

Le procédé de l'invention peut être mis en oeuvre par des moyens programmés à base de processeurs, ou par des logiques câblées, ou encore par des solutions technologiques intermédiaires. Il permet une découpe des tâches à réaliser temporelle plutôt que fonctionnelle. C'est ainsi qu'il permet d'intégrer le démodulateur et le décodeur convolutif cyclique dans le récepteur paquet et supprime la quantification définie par l'interface des données entre démodulateur et décodeur. Il n'y a pas de dégradation de performances du décodage pondéré dû à la quantification de ses entrées.

Le type d'encodage et de décodage décrit est avantageux même pour les conditions de transmissions habituelles.

Lors d'expériences menées par la demanderesse, il a été observé qu'au-delà de cycles de 60 bits et en deçà de 1000 bits pour le code K=7, R=½, (et au-delà de 100 bits et en deçà de 250 bits pour le code (9,½), les performances sont optimales.

Pour les grands paquets, la découpe en plusieurs cycles supprime la propagation des erreurs puisque, par construction, les cycles sont indépendants.

L'invention a été développée avec un encodage rebouclé séparé. L'intérêt de l'encodage séparé est une utilisation plus aisée du décodage sans réduction de la capacité de correction du code. En effet :
- d'une part l'opération finale de régénération des données dans le décodeur 16 est inutile ;
- d'autre part la robustesse système est augmentée : lorsque la capacité de décodage est dépassée, on peut transmettre le flot incident (non corrigé) plutôt que les corrections erronées.

Le décodage préconisé limite et minimise les paquets d'erreurs à l'intérieur du cycle.

Le nombre de cycles pour lesquels le rebouclage est impossible est suffisamment faible pour ne pas créer de contraintes système.

La puissance de calcul nécessaire est similaire au cas non rebouclé.

De plus, la démonstration de possibilité de rebouclage permet une quantification précise des tailles de cycles fonctionnels, et ce sans faire d'inversion de matrice.

On n'est nullement limité dans le choix des polynômes de contrôle puisque l'invention ne dépend pas du tout du choix des polynômes générateurs. La taille et la valeur des polynômes générateurs sont arbitraires. A titre indicatif, des résultats probants sont obtenus dans les cas (K, R) de : (7, ½) (exemple donné), (7, ¾), (9, ½) et (9, ¾). Des simulations peuvent être réalisées par des techniques numériques avec un générateur de bruit pseudo-aléatoire.

## Revendications

1. Procédé d'encodage et/ou de décodage convolutif de bits utilisateur, **caractérisé en ce que** l'on soumet lesdits bits utilisateur à un système d'équations de contrôle glissant de longueur finie, rebouclé sur lui-même.

2. Procédé selon la revendication 1, mise en oeuvre pour l'encodage, **caractérisé en ce que** l'encodage est du type dit "séparé", la concaténation des bits utiles et des bits de redondance constituant les bits présentés en sortie.

3. Procédé selon la revendication 1 ou 2, **caractérisé en ce que** les bits à présenter en sortie sont regroupés sur une ou plusieurs portion(s) rebouclée(s), formant un ou plusieurs cycles(s) respectif(s).

4. Procédé selon la revendication 3, caractérisé en lesdits cycles sont caractérisés chacun par le quadruplet de paramètres suivants:
- la taille du cycle C (en bits transmis) ;
- le nombre de bits utiles K concernés par le système de contrôle à chaque instant, ce nombre K étant la longueur de contrainte de sorte que (K-1) est le degré maximum des polynômes associés au système d'équations de contrôle ;
- le rendement R, c'est-à-dire le nombre de bits utiles sur le nombre de bits transmis du cycle ; et
- les coefficients des équations du système de contrôle.

5. Procédé selon la revendication 4, **caractérisé en ce que** les paramètres de cycle sont sélectionnés de manière indépendante d'un cycle à un autre.

6. Procédé selon l'une quelconque des revendications 1 à 5, **caractérisé en ce que** les cycles, même s'ils appartiennent à un même ensemble utilisateur, sont encodés indépendamment et sont de ce fait décodés indépendamment, sans échange de données ou de paramètres entre cycles.

7. Procédé selon l'une quelconque des revendications 1 à 6, **caractérisé en ce que** un ou plusieurs cycles sont regroupés en paquets numériques distincts afin de desservir une transmission paquets lorsque nécessaire, une transmission dite continue étant un cas particulier d'un paquet unique de longueur arbitraire.

8. Procédé selon l'une quelconque des revendications 1 à 7, **caractérisé en ce que** l'on adapte la qualité de service (taux de perte cycles ; taux d'erreurs moyen et retard de transmission) à la nature des données à traiter en adaptant le paramétrage variable de chaque cycle au niveau de l'encodage et du décodage, la qualité de service étant individualisée suivant la nature des données (voix ; données numériques ; signalisation ; en-tête ; etc...).

9. Procédé selon l'une quelconque des revendications 1 à 8, mis en oeuvre pour le l'encodage, **caractérisé en ce qu'**il comprend une étape d'embrouillage de tout ou une partie des bits transmis du cycle.

10. Procédé selon l'une quelconque des revendications 1 à 9, mis en oeuvre sur processeur(s) fonctionnant avec découpe temporelle plutôt que fonctionnelle des tâches à réaliser, sans passation de données entre cycles, ces derniers étant indépendants, permettant une intégration de la démodulation et du décodage convolutif cyclique dans un même processeur avec réduction de la perte de quantification pouvant être induite par l'interface des données entre un démodulateur et un décodeur classiques.

11. Procédé selon l'une quelconque des revendications 1 à 10, mis en oeuvre pour l'encodage, **caractérisé en ce que** l'encodage comprend les étapes successives de :
- calcul de la réponse impulsionnelle séparée correspondant à la taille C d'un cycle à encoder, et
- d'encodage du message incident.

12. Procédé selon la revendication 11, **caractérisé en ce que** la réponse impulsionnelle séparée est précalculée pour chaque type de cycle, et **en ce que** la réponse impulsionnelle, lorsqu'elle existe, est unique.

13. Procédé selon la revendication 12, caractérisé en que l'on réalise une concaténation de cycles de tailles sélectionnées afin d'éviter les tailles de cycles ne rebouclant pas et de s'ajuster à la longueur du message désiré.

14. Procédé selon l'une quelconque des revendications 11 à 13, **caractérisé en ce que** l'encodage est réalisé à l'aide d'une réponse impulsionnelle séparée calculée à partir d'un message unitaire (MU).

15. Procédé selon la revendication 14, **caractérisé en ce que** le message unitaire (MU) est constitué d'un ensemble de bits, dont un seul a la valeur binaire "1".

16. Procédé selon l'une quelconque des revendications 11 à 15, **caractérisé en ce que** le calcul de la réponse impulsionnelle est réalisé à l'aide d'une séquence de bits de redondance (E1 à EK-1) apposée avant le début du message unitaire (MU), la valeur des bits formant ladite séquence étant sélectionnée de manière à ce que l'on retrouve, après le calcul de la réponse impulsionnelle, la même séquence de valeurs dans les derniers bits correspondant (F1 à FK-1) de la réponse impulsionnelle.

17. Procédé selon la revendication 16, **caractérisé en ce que** la valeur des bits de redondance (E1 à EK-1) est calculée en essayant toutes les combinaisons possibles de valeurs de bits, jusqu'à obtention de ladite séquence de valeurs dans les derniers bits (F1 à FK-1) du message unitaire après calcul de la réponse impulsionnelle.

18. Procédé selon l'une quelconque des revendications 11 à 17, **caractérisé en ce que** l'encodage comprend en outre un encodage général des données par rotations et additions de la réponse impulsionnelle séparée calculée à partir du message unitaire (MU).

19. Procédé selon l'une quelconque des revendications 3 à 18, **caractérisé en ce que** chaque cycle comporte un nombre faible de bits, par exemple compris dans une plage C de 64 à 150 bits pour (K=7, R= ½) , afin de minimiser la propagation d'erreurs et de garantir la résistance aux perturbations volontaires ou non.

20. Procédé de décodage de données (P) ayant été codées par cycle, notamment par un procédé d'encodage selon l'une quelconque des revendications 1 à 19, **caractérisé en ce que**, pour un cycle donné, on commence le décodage à un lieu robuste (LR), de vraisemblance relativement élevée, et l'on termine le décodage à un lieu faible (LF) de vraisemblance faible en s'affranchissant du sens d'écoulement du temps, la vraisemblance du lieu étant calculée sur un nombre de symboles proportionnel au moins à la longueur de contrainte K.

21. Procédé selon la revendication 20, mis en oeuvre avec un seul encodeur cyclique, **caractérisé en ce que** le point de départ du décodage est le lieu le plus robuste (LR) et le point de terminaison du décodage est le lieu le plus faible (LF) du cycle à décoder.

22. Procédé selon l'une quelconque des revendications 20 ou 21, **caractérisé en ce que** la vraisemblance d'un lieu est déterminée en fonction de la qualité du signal local issu soit du démodulateur, (par exemple de la porteuse reconstituée sur chaque symbole, intégrée sur la durée de l'hypothèse de décodage auquel elle est associée), soit de la sortie d'un autre décodeur interne convolutif ou d'un autre décodeur externe bloc.

23. Procédé selon l'une quelconque des revendications 20 à 22, **caractérisé en ce que** le décodage commence par le calcul de la vraisemblance de l'hypothèse sans erreur dans le lieu robuste (LR) choisi, ainsi que de celles ayant un nombre limité d'erreurs au même endroit.

24. Procédé selon l'une quelconque des revendications 20 à 23, **caractérisé en ce que** le décodage est réalisé par progression dans deux directions opposées (F1 et F2) pour progresser sur deux côtés d'un lieu faible (LF), chaque direction donnant un jeu d'hypothèses respectives.

25. Procédé selon l'une quelconque des revendications 20 à 24, **caractérisé en ce que** le décodage est poursuivi symbole démodulé par symbole démodulé vers le lieu faible (LF), par augmentation de la durée de la vraisemblance associée à l'hypothèse, en conservant à chaque pas les meilleures hypothèses au sens de la vraisemblance.

26. Procédé selon la revendication 25, **caractérisé en ce qu'**à partir des hypothèses respectives, on produit une hypothèse totale, choisie comme étant celle qui permet de satisfaire les équations du système de contrôle pas à pas tout autour du cycle.

27. Procédé selon l'une quelconque des revendications 20 à 26, **caractérisé en ce que** l'hypothèse retenue est celle qui présente la vraisemblance maximum.

28. Emetteur, **caractérisé en ce qu'**il comporte un encodeur configuré pour réaliser le procédé d'encodage selon l'une quelconque des revendications 1 à 27.

29. Récepteur, **caractérisé en ce qu'**il comporte un décodeur configuré pour réaliser le procédé de décodage selon l'une quelconque des revendications 1 à 27.
